# EUROPEAN PATENT APPLICATION

(11) **EP 4 024 134 A1**
(43) Date of publication of application: **06.07.2022**
(21) Application number: 20856582.0
(22) Date of filing: 08.07.2020
(51) Int. Cl.: G03F 7/027, G03F 7/004, H05K 1/03

(54) **RESIN COMPOSITION AND APPLICATIONS THEREOF**

(30) Priority: 28.08.2019 CN 201910804508
(71) Applicant: Zhejiang First Advanced Material R&D Institute Co., Ltd., Hangzhou, Zhejiang 311305 (CN)
(72) Inventor: LIN, Xiaoying, Hangzhou, Zhejiang 311305 (CN); TONG, Rongbai, Hangzhou, Zhejiang 311305 (CN); LI, Weijie, Hangzhou, Zhejiang 311305 (CN); QIAN, Weiqiang, Hangzhou, Zhejiang 311305 (CN); ZHOU, Guangda, Hangzhou, Zhejiang 311305 (CN); LIN, Jianhua, Hangzhou, Zhejiang 311305 (CN)
(74) Representative: Tiburzi, Andrea
(86) International application number: PCT/CN2020/100911
(87) International publication number: WO 2021/036527

(57) **Abstract**

A resin composition and a use thereof is provided. The resin composition includes, in parts by weight, 100 parts of an alkali-soluble resin, 5-30 parts of acrylate monomers, 0.1-10 parts of photoinitiator, 10-30 parts of a first epoxy resin and 0-15 parts of a second epoxy resin. The first epoxy resin is a low-dielectric epoxy resin with a dielectric constant of <3.5, and the second epoxy resin is different from the first epoxy resin. With the addition of the low epoxy resin with the dielectric constant of < 3.5, and by adjusting the ratio of the components, the resin composition significantly reduces the dielectric constant and dielectric loss, the dielectric constant is reduced to 3.0 or less, and the dielectric loss is reduced to 0.008 or less. In addition, the resin composition also provides excellent heat resistance, resolution, and a reduced resilience, and also provides relatively improved flexibility and bending resistance. At the same time, the resin composition is a photosensitive resin composition and allows an image transfer by means of photographic development.

## Description

### TECHNICAL FIELD

The present disclosure relates to the field of printing circuit board (PCB), and in particular, to a resin composition and a use thereof, and in more particular, to a resin composition for high-frequency and high-speed PCB.

### BACKGROUND

With the advent of the 5G era, the current trend of miniaturization, thinning, high integration, and full-screen display has made terminal equipment increasingly demanding support materials. Since 5G signals will use higher frequencies and faster transmission speeds in the transmission process, PCB and FPCB materials are required to reduce the electrical signal loss in the high-frequency region, specifically the region with a frequency above 1GHz, which requires PCB and FPCB materials have low dielectric constant (Dk) and dielectric loss (Df). Among them, Dk should be less than or equal to 3.0, and Df should be less than or equal to 0.008.

In the prior art, the photosensitive polyimide cover film has a low Dk of 3.0 or less, but the Df is higher than 0.01. The traditional PI cover film (CVL) is composed of an epoxy adhesive layer and a polyimide resin layer. The high polarity of the epoxy adhesive layer causes the Dk of the traditional CVL to be as high as 3.5 or more. Existing solder mask inks, flexible inks, and PIC photosensitive covering films all contain a large amount of highly polar epoxy resin and a higher concentration of polar groups, and the dielectric properties of the materials are also poor.

Therefore, the industry is eager to have low dielectric constant and low dielectric loss photosensitive solder resist protective layer material (such as cover film, solder mask ink or photosensitive cover film, etc.). In the field of copper clad laminates (CCL), the development of low-dielectric materials basically uses polytetrafluoroethylene resin, maleimide resin, thermosetting polyphenylene ether resin, cyanate resin, polyimide resin, low-dielectric epoxy resin and liquid crystal polymers. While, in the field of solder resist protective layers, there are few researches on low dielectric cover films, low dielectric solder mask inks and low dielectric photosensitive cover films.

Chinese patent CN108287451A discloses a low dielectric photosensitive cover film resin composition. The dielectric constant of the material is reduced by adding a fluorinated polymer to the epoxy acrylic resin system. The fluorinated polymer has a particle size of 0.1-7 microns and is easy to agglomerate and precipitate and has poor compatibility with the host resin, affecting the overall dielectric and light transmittance of the material. Chinese patent CN109923176A discloses a low-dielectric cover film for high-frequency signal transmission. Its technical route is to add low-dielectric loss polyphenylene ether resin and imidazole compounds, low-polarity biphenyl type, naphthalene ring skeleton epoxy resin, etc., to reduce the dielectric constant of the epoxy adhesive layer in the traditional CVL. But the composition, like the traditional CVL, cannot be used for image transfer through photosensitive development. It still requires die cutting to open the window. The accuracy of the window opening is low and difficult to meet the resolution requirements of high-precision, ultra-thin integrated circuit boards.

Based on the above reasons, it is necessary to provide a low dielectric photosensitive solder resist protective layer material with better performance in terms of photosensitivity, dielectric properties, flexibility, and processability.

### SUMMARY

The main object of the present disclosure is to provide a resin composition and a use thereof, so as to solve the problem that the resin composition in the prior art is not suitable used for high-frequency and high-speed printing due to the lack of photosensitivity, dielectric properties, flexibility or processability in the circuit board.

In order to achieve the above objective, according to one aspect of the present disclosure, it is provided a resin composition. In parts by weight, the resin composition comprises 100 parts of alkali-soluble resin, 5-30 parts of acrylate monomers, 0.1-10 parts of photoinitiator, 10-30 parts of a first epoxy resin and 0-15 parts of a second epoxy resin; among them, the first epoxy resin is a low-dielectric epoxy resin with a dielectric constant of <3.5, and the second epoxy resin is different from the first epoxy resin.

Further, the low dielectric epoxy resin is an epoxy resin containing at least two epoxy groups and an epoxy equivalent of 160-2000 g/eq; the low dielectric epoxy resin is preferably selected one or more from a group consisting of biphenyl type epoxy resin, naphthalene ring type epoxy resin, naphthol type epoxy resin, naphthylene ether type epoxy resin, polyphenylene ether type epoxy resin, dicyclopentadiene phenolic type epoxy resin and crystalline fluorene type epoxy resin, and more preferably the naphthalene ring type epoxy resin.

Further, the biphenyl type epoxy resin has a structure shown in formula I: 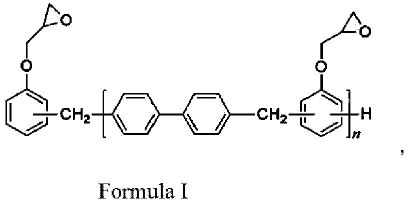 n is a natural number of 1 to 10;
the naphthalene type epoxy resin has a structure shown in formula II: 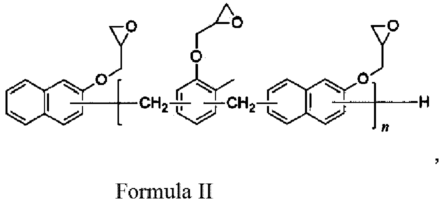 n is a natural number of 1 to 10;
the naphthol type epoxy resin has a structure shown in formula III: 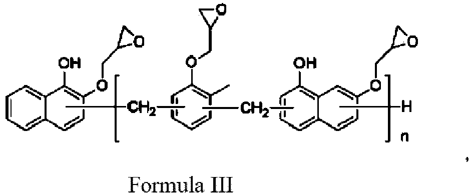 n is a natural number of 1 to 10;
the naphthyl ether type epoxy resin has a structure shown in formula IV: 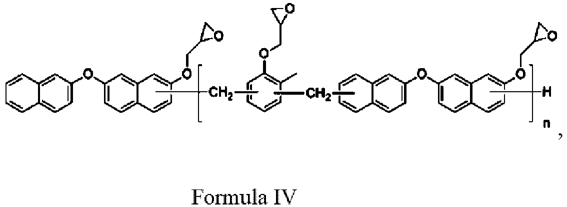 n is a natural number of 1 to 10;
the polyphenylene ether type epoxy resin has a structure shown in formula V: 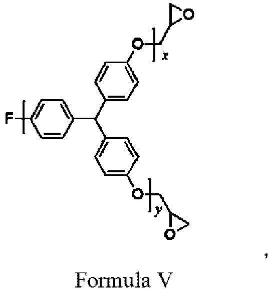 x and y are natural numbers of 1 to 10, respectively;
the bicyclopentadiene phenolic type epoxy resin has a structure shown in formula VI: 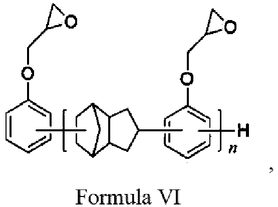 n is a natural number of 1 to 10;
the crystalline anthracene type epoxy resin has a structure shown in formula VII:

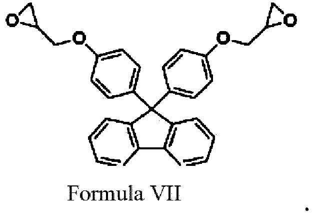

Further, an acid value of the alkali-soluble resin is 60 to 150 mg KOH/g;
preferably, the alkaline soluble resin is selected one or more from a group consisting of photosensitive epoxy acrylic resin, Phenylacrylic resin, photosensitive polyurethane acrylic acid resin;
preferably, the photosensitive epoxy acrylic resin is selected one or more from a group consisting of carboxylic acid-modified bisphenol A epoxy resin, carboxylic acid modified bisphenol F epoxy resin, carboxylic acid modified phenolic epoxy resin, carboxylic acid modified o-cresol epoxy resin;
preferably, the Phenylacrylic resin is selected from carboxylic acid-modified Phenylacrylic resins with a weight average molecular weight of 3-20w and a glass transition temperature of 90-150°C;
preferably, the photosensitive polyurethane acrylic acid resin is selected from one or more of an aliphatic polyurethane acrylic resin, an alicyclic urethane acrylic resin, an aromatic polyurethane acrylic acid resin.

Further, the weight average molecular weight of the acrylate monomer is 200 to 2000, and the glass transition temperature is -20 to 100°C;
preferably, the acrylate monomer is selected one or more from a group consisting of (ethoxy) phenol (meth)acrylate, stearic acid acrylate, ethoxy (propoxy) nonylphenol (meth)acrylate, ethoxy (propoxy) tetrahydrofurfuryl (meth)acrylate, 1,6-hexanediol diacrylate, PPG (400) diacrylate, tricyclodecane dimethanol diacrylate, dioxane alkyl glycol diacrylate, ethoxylated (propoxylated) bisphenol A di(meth)acrylate, polyethylene glycol (400) diacrylate, polypropylene glycol (600) diacrylate, ethoxylated (propoxylated) bisphenol A di(meth)acrylate, pentaerythritol triacrylate, tris(2-hydroxyethyl) isocyanurate triacrylate, dipentaerythritol hexaacrylate, ethoxylated pentaerythritol tetraacrylate, dipentaerythritol hexaacrylate.

Further, the photoinitiator comprises a photopolymerization initiator and a photosensitizer, and a weight ratio of the photopolymerization initiator and the photosensitizer is (2-20):1;
preferably, the photopolymerization initiator is selected one or more from a group consisting of 1-hydroxycyclohexyl phenyl ketone, 2-hydroxy-2-methyl-1-phenyl-1-acetone, 1-[4-(2-hydroxy)-phenyl)-3-hydroxy-2-methyl-1-acetone-1 -ketone, 2-methyl-1-(4-methylthiophenyl)-2-morpholine- 1-acetone, 2-phenylbenzyl-2-dimethylamine-1-(4-morpholinbenzylphenyl) butanone, 2,4,6-trimethylbenzoyl-diphenylphosphorus oxide, bis(2,4,6-trimethylbenzoyl)phenyl phosphine oxide and ethyl 2,4,6-trimethylbenzoylphenylphosphonate;
preferably, the photosensitizer is selected one or more from a group consisting of 2,4-diethyl oxalate, 2-isopropyl thioxanthone, 2,4-diethyl thioxanthone, benzophenone, polybutylene glycol bis(9-oxo-9H-thioxanthoxyacetic acid) ester.

Further, in parts by weight, the resin composition further comprises 3-10 parts of a toughening resin;
preferably, the toughening resin is selected one or more from a group consisting of core-shell rubber toughened epoxy resin, thermoplastic elastomer, polyurethane elastomer, liquid rubber, and rubber powder.

Further, in parts by weight, the resin composition further comprises 0-5 parts of pigment and 0.01-5 parts of additive; the additive is selected one or more from a group consisting of thermal curing accelerator, dispersant, leveling agent, defoaming agent;
preferably, the pigment is selected one or more from a group consisting of benzidine yellow, phthalocyanine green, phthalocyanine blue, carbon black, silicon dioxide, barium sulfate, calcium sulfate, talc powder, hydrotalcite;
preferably, the thermal curing accelerator is a latent thermal curing accelerator, and more preferably the thermal curing accelerator is selected one or more from a group consisting of boron trifluoride ethylamine complex, adipic acid dihydrazide, p-hydroxybenzoic acid hydrazide, isophthalic acid hydrazide, diaminodiphenyl sulfone, dicyandiamide and derivatives thereof.

Further, in parts by weight, the resin composition comprises 100 parts of the alkali-soluble resin, 5-30 parts of the acrylate monomer, and 0.1-10 parts of the photoinitiator, 10-30 parts of the first epoxy resin, 0-15 parts of the second epoxy resin, 5-7 parts of the toughening resin, 1-5 parts of the pigment, and 1-5 parts of the additive.

According to another aspect of the present disclosure, it is also provided a use of a resin composition in a field of high-frequency and high-speed PCB.

According to yet another aspect of the present disclosure, it is also provided method for preparing a solder resist protective layer for a high-frequency and high-speed PCB, it comprises the following steps:
roll-coating a resin composition above mentioned into a film to form a wet film;
performing hot roll filming, exposing, developing, and thermal curing sequentially after the wet film is pre-dried, so as to obtain the solder resist protective layer.

According to one aspect of the present disclosure, a thickness of the wet film is 25-50 µm;
preferably, in a pre-drying process, a pre-drying temperature is 80°C-100°C, and a duration is 15-30 min;
preferably, an exposure energy during an exposing process is 100-500mJ cm⁻²;
preferably, during a developing process, a developer used is 0.8-1.2wt% Na₂CO₃ solution, and a developing time is 30-60s, a developing temperature is 27-33 °C, and a spray pressure is 0.2-0.4 MPa;
preferably, during a thermal curing process, a thermal curing temperature is 150-200°C, and a thermal curing duration is 1-1.5h.

The resin composition provided by the present disclosure includes 100 parts by weight of alkali-soluble resin, 5-30 parts of acrylate monomer, 0.1-10 parts of photoinitiator, 10-30 parts of first epoxy resin and 0-15 parts of the second epoxy resin; wherein the first epoxy resin is a low dielectric epoxy resin with a dielectric constant of less than 3.5, and the second epoxy resin is different from the first epoxy resin. By adding a low-dielectric epoxy resin with a dielectric constant of <3.5, and then adjusting the ratio of each component, the resin composition significantly reduces its dielectric constant and dielectric loss, and the dielectric constant can be reduced to below 3.0, and the dielectric loss can be reduced to less than 0.008. In addition to good dielectric properties, the resin composition also has good heat resistance, resolution, low resilience, and relatively good flexibility and bending resistance. At the same time, the resin composition is a photosensitive resin composition and can perform image transfer by photosensitive development. The above reasons enable the resin composition of the present disclosure to meet the requirements of high-frequency and high-speed PCB and FPC circuit boards, and has broad application prospects.

### DESCRIPTION OF EMBODIMENTS

It should be noted that the embodiments in the present disclosure and the features in the embodiments can be combined with each other without conflict. The present disclosure will be described in detail below in conjunction with embodiments.

As described in the background of the present disclosure, the resin composition for printed circuit boards in the prior art is not suitable for application in high-frequency and high-speed printed circuit boards due to excessively high dielectric constant or dielectric loss.

In order to solve this problem, the present disclosure provides a resin composition, which is characterized in that, by weight, the resin composition includes 100 parts of alkali-soluble resin, 5-30 parts of acrylic monomer, 0.1-10 parts of photoinitiator, 10-30 parts of the first epoxy resin and 0-15 parts of the second epoxy resin; wherein the first epoxy resin is a low-dielectric epoxy resin with a dielectric constant of <3.5, and the second epoxy resin is different from the first epoxy resin.

The above-mentioned resin composition provided by the present disclosure significantly reduces its dielectric constant and dielectric loss by adding a low dielectric epoxy resin with a dielectric constant of <3.5, and then adjusting the proportion of each component, and the dielectric constant can be lowered to below 3.0, the dielectric loss can be lowered to below 0.008. In addition to good dielectric properties, the resin composition also has good heat resistance, resolution, low resilience, and relatively good flexibility and bending resistance. At the same time, the resin composition is a photosensitive resin composition and can perform image transfer by photosensitive development. The above reasons enable the resin composition of the present disclosure to meet the requirements of high-frequency and high-speed PCB and FPC circuit boards, and has broad application prospects.

In order to further improve the soldering heat resistance, developability, adhesion, etc. of the resin composition, in a preferred embodiment, the low-dielectric epoxy resin may be a kind of epoxy resin containing at least two epoxy groups, and the epoxy equivalent is 160~2000g/eq. Preferably, the low dielectric epoxy resin may include, but is not limited to, one or more selected from a group consisting of biphenyl type epoxy resin, naphthalene ring type epoxy resin, naphthol type epoxy resin, naphthylene ether type epoxy resin, polyphenylene ether type epoxy resin, dicyclopentadiene type novolac epoxy resin and crystalline epoxy resin, more preferably naphthalene ring-type epoxy resin. In addition to reducing the dielectric constant and dielectric loss of the resin composition, the above-mentioned types of low dielectric epoxy resins also help to improve the heat resistance and other properties of the resin composition. They are all fluorine-free epoxy resins, and also have a great advantage in terms of preparation cost.

More preferably, the above several types of low dielectric epoxy resins respectively have the following chemical structures:

The biphenyl type epoxy resin has the structure shown in formula I: 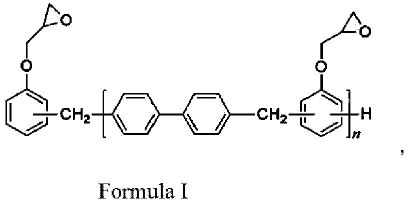 n is a natural number from 1 to 10;
The naphthalene ring epoxy resin has the structure shown in formula II: 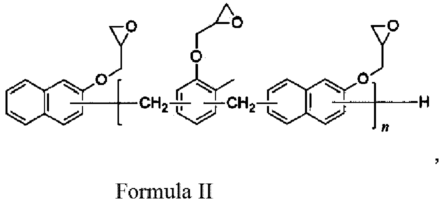 n is a natural number from 1 to 10;
The naphthol type epoxy resin has the structure shown in formula III: 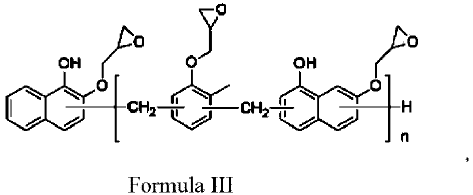 n is a natural number from 1 to 10;
The naphthylene ether type epoxy resin has the structure shown in formula IV: 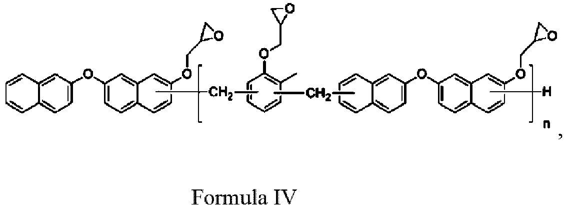 n is a natural number from 1 to 10;
The polyphenylene ether type epoxy resin has the structure shown in formula V: 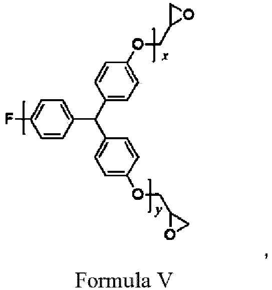 x and y are natural numbers from 1 to 10 respectively
The dicyclopentadiene type novolac epoxy resin has the structure shown in formula VI: 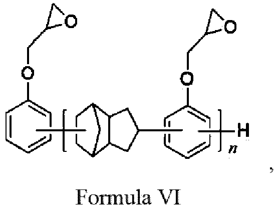 n is a natural number from 1 to 10;
The crystalline fluorene type epoxy resin has the structure shown in formula VII:

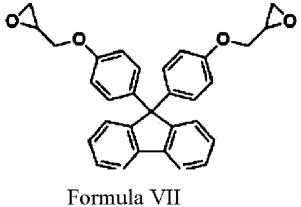

The low-dielectric epoxy resins of these several structures may be applied to the resin composition, such that the performance of the resin composition can be further improved and more suitable used in high-frequency and high-speed printed circuit boards as its solder mask protective layer material. It should be noted that the above-mentioned low-dielectric epoxy resins are commercially available.

The above-mentioned second epoxy resin can be other general-purpose epoxy resins other than the low-dielectric epoxy resin. Of course, considering the compatibility with the low-dielectric epoxy resin and the improvement of the performance of the resin composition, in a preferred embodiment, the above-mentioned second epoxy resin may include, but is not limited to, one or more from Nanya epoxy resin NPES-901, NPEL-128, NPES-904, NPCN704, or DIC epoxy resin Epiclon-1050, Epiclon-830, Epiclon N-695.

In a preferred embodiment, the acid value of the alkali-soluble resin is 60-150 mg KOH/g. When the acid value is lower than 60 mg KOH/g, the development is poor, causing problems such as incomplete development such as residual gum; and when the acid value is higher than 150mg KOH/g, excessive development will cause the line width and line spacing to deviate from the standard value. Preferably, the alkali-soluble resin is selected from one or more of photosensitive epoxy acrylic resin, Phenylacrylic resin, and photosensitive polyurethane acrylic resin. The use of these types of alkali-soluble resins can further improve the photosensitive and developing ability of the resin composition, thereby helping to improve the resolution of the resin composition after film formation, and meeting the high-precision requirements of the circuit board. Among them, preferably, the photosensitive epoxy acrylic resin includes but is not limited to one or more of carboxylic acid modified bisphenol A type epoxy resin, carboxylic acid modified bisphenol F type epoxy resin, carboxylic acid modified novolac epoxy resin, carboxylic acid modified o-cresol epoxy resins. As the photosensitive epoxy acrylic resin, the following commercially available products can also be used: Nippon Kayaku's ZAR-1035, ZAR-2000, ZAR-1000, ZFR-1491H, CCR-1291H, CCR-1235, etc. Preferably, the Phenylacrylic resin is selected from carboxylic acid-modified benzene acrylic resins with a weight average molecular weight of 3-20w and a glass transition temperature of 90-150°C. Preferably, the photosensitive polyurethane acrylic resin includes but is not limited to one or more of aliphatic polyurethane acrylic resin, alicyclic urethane acrylic resin and aromatic urethane acrylic resin. After using the above alkali-soluble resin, the overall performance of the resin composition can be better.

The above-mentioned acrylate monomers can be of types commonly used in the field of photocuring, for example, monofunctional or multifunctional acrylate monomers can be adopted. In a preferred embodiment, the weight average molecular weight of the above-mentioned acrylate monomer is 200-2000, and the glass transition temperature is -20-100°C, so that the hardness, flexibility, resilience and developability of the cured film can be controlled. Preferably, the acrylic monomers may include but are not limited to one or more selected from a group consisting of (ethoxy) phenol (meth) acrylate, stearate acrylate, ethoxy (propoxy) nonyl phenol (meth) acrylate, ethyl oxy (propoxy) tetrahydrofurfuryl (meth)acrylate, 1,6-hexanediol diacrylate, PPG (400) diacrylate, tricyclodecane dimethanol diacrylate, dioxa cyclohexanediol diacrylate, ethoxylated (propoxylated) bisphenol A di(meth)acrylate, polyethylene glycol (400) diacrylate, polypropylene glycol (600) diacrylate, ethoxy (propoxy) trimethylolpropane tri(meth)acrylate, pentaerythritol triacrylate, tris(2-hydroxyethyl) isocyanurate triacrylate, dipentaerythritol hexaacrylate, ethoxylated pentaerythritol tetraacrylate and dipentaerythritol hexaacrylate.

In order to further improve the photocuring performance of the resin composition, in a preferred embodiment, the photoinitiator may include a photopolymerization initiator and a photosensitizer, and the weight ratio of the photopolymerization initiator to the photosensitizer may be (2-20): 1. The use of the photosensitizer helps to improve the photosensitive performance of the resin composition, and the ratio of them is controlled within the above range, such that the photocurable performance of the resin composition can be better. Preferably, the photopolymerization initiator may include, but is not limited to, one or more from a group consisting of 1-hydroxycyclohexyl phenyl ketone, 2-hydroxy-2-methyl-1-phenyl-1-propanone, 1- [4-(2-hydroxy)-Phenyl)-3-hydroxy-2-methyl-1-acetone-1-one, 2-methyl-1-(4-methylthiophenyl)-2-morpholine-1-acetone,2-benzene Benzyl-2-dimethylamine-1-(4-morpholinebenzylphenyl) butanone, 2,4,6-trimethylbenzoyl-diphenylphosphorus oxide, bis(2,4,6 -Trimethylbenzoyl) phenyl phosphine oxide, 2,4,6-trimethylbenzoyl phenyl phosphonate ethyl ester. Preferably, the photosensitizer may include but is not limited to one or more from a group consisting of diethyl 2,4-oxalate, 2-isopropylthioxanthone, 2,4-diethylthioxanthone, benzophenone, polybutylene glycol bis(9-oxo-9H -thixanthoxyacetate).

In a preferred embodiment, in parts by weight, the resin composition may further include 3-10 parts of toughening resin. The use of toughening resin is beneficial to improve the bending properties of the protective layer formed by the resin composition, and the performance of the protective layer in terms of heat resistance and resilience can be better. Preferably, the toughening resin may include, but is not limited to, one or more of core-shell rubber toughened epoxy resin, thermoplastic elastomer, polyurethane elastomer, and rubber powder. The commercially available core-shell rubber toughened epoxy resin can use Kaneka's MX154, MX113, MX158, M257, etc. The thermoplastic elastomers can use styrene-butadiene block copolymer (SBS), styrene-poly(ethylene-ethylene/propylene) block-polystyrene (SEEPS), styrene-isoprene-styrene block copolymer (SIS), etc.. The commercially available polyurethane elastomers can be RHC-730 from Dainichiseika, Artpearl C-300T, Artpearl C-400T, Artpearl C-600T, Artpearl SE-050T, Artpearl GR-50W from Negami Chemical Industry etc.. The rubber powder commercially available products can be Kaneka's MZ100, MZ 210, MZ711, etc..

In order to further improve the overall performance of the resin composition, in a preferred embodiment, based on parts by weight, the resin composition may further include 0-5 parts of pigment and 0.01-1 parts of auxiliary agents. The above-mentioned pigments, fillers and auxiliary agents can be of common types in this field. Preferably, the pigment may be selected from benzidine yellow, phthalocyanine green, phthalocyanine blue, carbon black and the like. In order to improve heat resistance and reduce costs, it is preferable to add fillers, such as silica, barium sulfate, calcium sulfate, talc, hydrotalcite, etc. at the same time. Preferably, the auxiliary agent is selected from one or more of thermal curing accelerators, dispersants, leveling agents, and defoamers. The selection of a thermal curing accelerator is helpful to improve the thermal curing performance of the resin composition, and from the viewpoint of extending the storage period and improving the storage performance at room temperature, the thermal curing accelerator is more preferably a latent thermal curing accelerator, the thermal curing accelerator is more preferable one or more selected from boron trifluoride ethylamine complex, adipic acid dihydrazide, p-hydroxybenzoic acid hydrazide, isophthalic acid hydrazide, diaminodiphenyl sulfone, dicyandiamide and derivatives thereof. The use of dispersants (such as BYK9077, BYK110, BYK168 and other wetting and dispersing agents), leveling agents (BYK394, BYK322, BYK UV3530 and other leveling agents) and defoamers (BYK015, BYK1730, BYK354 and other defoamers) helps to improve the stability, wettability, dispersibility, and film forming properties of the resin composition.

In a preferred embodiment, based on parts by weight, the resin composition may include 100 parts of alkali-soluble resin, 5-30 parts of acrylate monomer, 0.1-10 parts of photoinitiator, and 10-30 parts of the first epoxy resin, 0-15 parts of the second epoxy resin, 3-10 parts of toughening resin, 1-5 parts of pigment , and 1-5 parts of additives. If the weight relationship of each component is controlled within the above range, the performance of the resin composition can be better, and it is more suitable as a solder resist protective layer material for high-frequency and high-speed printed circuit boards.

According to another aspect of the present disclosure, the use (application) of the above-mentioned resin composition in the field of high-frequency and high-speed printed circuit boards is also provided.

According to one aspect of the present disclosure, it is also provided a method for preparing a solder resist protective layer for a high-frequency and high-speed printed circuit board, the method may include the following steps: roll coating the above-mentioned resin composition into a film to form a wet film; performing hot roll filming, exposing, developing, and thermal curing in sequence after pre-drying, to obtain a solder resist protective layer. Using the above resin composition, the formed high-frequency and high-speed printed circuit board (PCB, FPC, etc.) has lower dielectric constant and dielectric loss, and has good performance in terms of heat resistance, bending property, resilience, and resolution.

In a preferred embodiment, the thickness of the wet film may be 25-50µm; preferably, during the pre-drying process, the pre-drying temperature may be 80-100°C and the duration may be 15-30 min; preferably, the exposure energy during the exposing process may be 100-500mJ cm⁻²; preferably, the developer used in the developing process may be 0.8-1.2wt% Na₂CO₃ solution, the developing time may be 30-60s, the developing temperature may be 27-33°C, and the spray pressure may be 0.2-0.4 MPa; preferably, during the thermal curing process, the thermal curing temperature may be 150--200° C, and the thermal curing time may be 1-1.5h.

The present disclosure will be further described in detail below in combination with specific embodiments, and these embodiments should not be construed as limiting the scope of protection claimed by the application.

### Example 1

Preparation of a resin composition for high-frequency and high-speed printed circuit boards: using 15g alkali-soluble photosensitive epoxy acrylic resin ZAR-1035 (with acid value 100mg KOH/g, solid content 64%), 2.5g acrylate monomer (including 1.5g 20EOBPDMA, 1.0g 10EOTMPTA), 0.5g photopolymerization initiator (including 0.2g 184, 0.3g 907), 0.05g photosensitizer (ITX), 3.5g epoxy resin (including 2.7g naphthalene ring type low dielectric epoxy resin, 0.8g toughened epoxy resin MX-154), 0.01g boron trifluoride ethylamine latent curing accelerator, 0.3g carbon black MA-7, 0.5g other additives (including 0.3g dispersant BYK168, 0.1 g leveling agent BYK 394, O.lg defoamer BYK354); milling with three rollers firstly; and then dissolving and dispersing with high-speed stirring; and filtering to obtain the glue solution, and storing it in dark light for later use.

### Example 2

Preparation of a resin composition for high-frequency and high-speed printed circuit boards: using 15g alkali-soluble photosensitive epoxy acrylic resin ZAR-1035 (with acid value 100mg KOH/g, solid content 64%), 2.5g acrylate monomer (including 1.5g 20EOBPDMA, 1.0g 10EOTMPTA), 0.5g photopolymerization initiator (including 0.2g 184, 0.3g 907), 0.05g photosensitizer (ITX), 3.5g epoxy resin (including 1.8g naphthalene ring type low dielectric epoxy resin, 0.9g NPES-901, 0.8g toughened epoxy resin MX-154), O.Olg boron trifluoride ethylamine latent curing accelerator, 0.3g carbon black MA-7, 0.5g other additives (including 0.3 g dispersant BYK168, O.lg leveling agent BYK 394, O.lg defoamer BYK354); milling with three rollers firstly; then dissolving and dispersing with high-speed stirring; and filtering to obtain the glue solution, and storing it in dark light for later use.

### Example 3

Preparation of a resin composition for high-frequency and high-speed printed circuit boards: using 15g alkali-soluble photosensitive epoxy acrylic resin ZAR-1035 (with acid value 100mg KOH/g, solid content 64%), 2.5g acrylate monomer (including 1.5g 20EOBPDMA, 1.0g 10EOTMPTA), 0.5g photopolymerization initiator (including 0.2g 184, 0.3g 907), 0.05g photosensitizer (ITX), 3.5g epoxy resin (including 0.96g naphthalene ring type low dielectric epoxy resin, 1.44g NPES-901, 0.8g toughened epoxy resin MX-154), O.Olg boron trifluoride ethylamine latent curing accelerator, 0.3g carbon black MA-7, 0.5g other additives (including 0.3 g dispersant BYK168, O.lg leveling agent BYK 394, O.lg defoamer BYK354); milling with three rollers firstly, then dissolving and dispersing with high-speed stirring; and filtering to obtain the glue solution, and storing it in dark light for later use.

### Example 4

Preparation of a resin composition for high-frequency and high-speed printed circuit boards: 15g alkali-soluble acrylic resin (with acid value 120mg KOH/g, molecular weight 150,000), 2.5g acrylate monomer (including 1.5g 20EOBPDMA, 1.0g 10EOTMPTA) , O.lg photopolymerization initiator (including 0.04g 184, 0.06g 907), O.Olg photosensitizer (ITX), 3.5g epoxy resin (including 1.8g naphthalene ring type low dielectric epoxy resin, 0.9g NPES-901, 0.8g toughened epoxy resin MX-154), O.Olg boron trifluoride ethylamine latent curing accelerator, 0.3g carbon black MA-7, 0.5g other additives (including 0.3g dispersant BYK168, O.lg leveling agent BYK 394, O.lg defoamer BYK354); milling with three rollers firstly, then dissolving and dispersing with high-speed stirring; and filtering to obtain the glue solution, and storing it in dark light for later use.

### Example 5

Preparation of a resin composition for high-frequency and high-speed printed circuit boards: using 15g alkali-soluble polyurethane epoxy acrylic resin UXE3000 (with acid value 100mg KOH/g, solid content 64%), 2.5g acrylate monomer (including 1.5g 20EOBPDMA , 1.0g 10EOTMPTA), 0.5g photopolymerization initiator (including 0.2g 184, 0.3g 907), 0.05g photosensitizer (ITX), 3.5g epoxy resin (including 1.8g naphthalene ring type low dielectric epoxy resin, 0.9g NPES-901, 0.8g toughened epoxy resin MX-154), O.Olg boron trifluoride ethylamine latent curing accelerator, 0.3g carbon black MA-7, 0.5g other additives (including 0.3g dispersant BYK168, O.lg leveling agent BYK 394, O.lg defoamer BYK354); milling with three rollers firstly, then dissolving and dispersing with high-speed stirring; and filtering to obtain the glue solution, and storing it in dark light for later use.

### Example 6

Preparation of a resin composition for high-frequency and high-speed printed circuit boards: using 15g alkali-soluble photosensitive epoxy acrylic resin ZAR-1035 (with acid value 100mg KOH/g, solid content 64%), 2.5g acrylate monomer (including 1.5g 20EOBPDMA, 1.0g 10EOTMPTA), 0.5g photopolymerization initiator (including 0.2g 184, 0.3g 907), 0.05g photosensitizer (ITX), 10g epoxy resin (including 1.8g dicyclopentadiene type low dielectric epoxy resin, 0.9g NPES-901, 0.8g toughened epoxy resin MX-154), O.Olg boron trifluoride ethylamine latent curing accelerator, 0.3g carbon black MA-7, 0.5g other additives (including 0.3g dispersant BYK168, O.lg leveling agent BYK 394, O.lg defoamer BYK354); milling with three rollers firstly, then dissolving and dispersing with high-speed stirring; and filtering to obtain the glue solution, and storing it in dark light for later use.

### Example 7

Preparation of a resin composition for high-frequency and high-speed printed circuit boards: using 15g alkali-soluble photosensitive epoxy acrylic resin ZAR-1035 (with acid value 100mg KOH/g, solid content 64%), 2.5g acrylate monomer (including 1.5g 20EOBPDMA, 1.0g 10EOTMPTA), 0.5g photopolymerization initiator (including 0.2g 184, 0.3g 907), 0.05g photosensitizer (ITX), 3.5g epoxy resin (including 2.1g dicyclopentadiene type low dielectric epoxy resin, 1.4g NPES-901); milling with three rollers firstly, then dissolving and dispersing with high-speed stirring; and filtering to obtain the glue solution, and storing it in dark light for later use.

### Example 8

Preparation of a resin composition for high-frequency and high-speed printed circuit boards: using 15g alkali-soluble photosensitive epoxy acrylic resin ZAR-1035 (with acid value 100mg KOH/g, solid content 64%), 2.5g acrylate monomer (including 1.5g 20EOBPDMA, 1.0g 10EOTMPTA), 0.5g photopolymerization initiator (including 0.2g 184, 0.3g 907), 0.05g photosensitizer (ITX), 3.5g epoxy resin (including 1.8g biphenyl type low dielectric epoxy resin, 0.9g NPES-901, 0.8g toughened epoxy resin MX-154), O.Olg boron trifluoride ethylamine latent curing accelerator, 0.3g carbon black MA-7, 0.5g other additives (including 0.3 g dispersant BYK168, O.lg leveling agent BYK 394, O.lg defoamer BYK354); milling with three rollers firstly, then dissolving and dispersing with high-speed stirring; and filtering to obtain the glue solution, and storing it in dark light for later use.

### Example 9

Preparation of a resin composition for high-frequency and high-speed printed circuit boards: using 15g alkali-soluble photosensitive epoxy acrylic resin ZAR-1035 (with acid value 100mg KOH/g, solid content 64%), 2.5g acrylate monomer (including 1.5 g 20EOBPDMA, 1.0g 10EOTMPTA), 0.5g photopolymerization initiator (including 0.2g 184, 0.3g 907), 0.05g photosensitizer (ITX), 3.5g epoxy resin (including 1.8g crystalline fluorene type epoxy resin, 0.9g NPES-901, 0.8g toughened epoxy resin MX-154), O.Olg boron trifluoride ethylamine latent curing accelerator, 0.3g carbon black MA-7, 0.5g other additives (including 0.3g dispersant BYK168, O.lg leveling agent BYK 394, O.lg defoamer BYK354); milling with three rollers firstly, then dissolving and dispersing with high-speed stirring; and filtering to obtain the glue solution, and storing it in dark light for later use.

### Example 10

Preparation of a resin composition for high-frequency and high-speed printed circuit boards: using 15g alkali-soluble photosensitive epoxy acrylic resin ZAR-1035 (with acid value 100mg KOH/g, solid content 64%), 0.48g acrylate monomer (including 0.29g 20EOBPDMA, 0.19g 10EOTMPTA), 0.01g photopolymerization initiator (including 0.004g 184, 0.006g 907), 0.001g photosensitizer (ITX), 3.5g epoxy resin (1.8g cyclopentadiene type low dielectric epoxy resin, 0.9g NPES-901, 0.8g toughened epoxy resin MX-154), O.Olg boron trifluoride ethylamine latent curing accelerator, 0.3g carbon black MA-7, 0.5g other additives (including 0.3g dispersant BYK168, O.lg leveling agent BYK 394, O.lg defoamer BYK354); milling with three rollers firstly, then dissolving and dispersing with high-speed stirring; and filtering to obtain the glue solution, and storing it in dark light for later use.

### Example 11

Preparation of a resin composition for high-frequency and high-speed printed circuit boards: using 15g alkali-soluble photosensitive epoxy acrylic resin ZAR-1035 (with acid value 100mg KOH/g, solid content 64%), 2.8g acrylate monomer (including 1.7g 20EOBPDMA, 1.1g 10EOTMPTA, 0.96g photopolymerization initiator (including 0.38g 184, 0.58g 907), O.lg photosensitizer (ITX), 3.5g epoxy resin (including 1.8g dicyclopentadiene type low dielectric ring oxygen resin, 0.9g NPES-901, 0.8g toughened epoxy resin MX-154), O.Olg boron trifluoride ethylamine latent curing accelerator, 0.3g carbon black MA-7, 0.5g other additives (including 0.3g dispersant BYK168, O.lg leveling agent BYK 394, O.lg defoamer BYK354); milling with three rollers firstly; then dissolving and dispersing with high-speed stirring; and filtering to obtain the glue solution, and storing it in dark light for later use.

### Comparative Example 1

Preparation of a resin composition for high-frequency and high-speed printed circuit boards: using 15g alkali-soluble photosensitive epoxy acrylic resin ZAR-1035 (with acid value 100mg KOH/g, solid content 64%), 2.5g acrylate monomer (including 1.5 g 20EOBPDMA, 1.0g 10EOTMPTA), 0.5g photopolymerization initiator (including 0.2g 184, 0.3g 907), 0.05g photosensitizer (ITX), 3.5g epoxy resin (including 2.7g NPES-901, 0.8g toughened epoxy resin MX-154), O.Olg boron trifluoride ethylamine latent curing accelerator, 0.3g carbon black MA-7, 0.5g other additives (including 0.3g dispersant BYK168, O.lg leveling agent BYK 394, O.lg defoamer BYK354); milling with three rollers firstly; then dissolving and dispersing with high-speed stirring; and filtering to obtain the glue solution, and storing it in dark light for later use.

### Comparative Example 2

Preparation of a resin composition for high-frequency and high-speed printed circuit boards: using 15g alkali-soluble photosensitive epoxy acrylic resin ZAR-1035 (with acid value 100mg KOH/g, solid content 64%), 2.5g acrylate monomer (including 1.5g 20EOBPDMA, 1.0g 10EOTMPTA), 0.5g photopolymerization initiator (including 0.2g 184, 0.3g 907), 0.05g photosensitizer (ITX), 3.5g epoxy resin (including 1.8g naphthalene ring type low dielectric epoxy resin, 0.9g NPES-901, 0.8g toughened epoxy resin MX-154), O.Olg boron trifluoride ethylamine latent curing accelerator, 0.3g carbon black MA-7, 0.5g other additives (including 0.3 g dispersant BYK168, O.lg leveling agent BYK 394, O.lg defoamer BYK354); milling with three rollers firstly, then dissolving and dispersing with high-speed stirring; and filtering to obtain the glue solution, and storing it in dark light for later use.

### Comparative Example 3

Preparation of a resin composition for high-frequency and high-speed printed circuit boards: using 15g alkali-soluble photosensitive epoxy acrylic resin ZAR-1035 (with acid value 100mg KOH/g, solid content 64%), 2.5g acrylate monomer (including 1.5g 20EOBPDMA, 1.0g 10EOTMPTA), 0.5g photopolymerization initiator (including 0.2g 184, 0.3g 907), 0.05g photosensitizer (ITX), 3.5g naphthalene ring type low dielectric epoxy resin, O.Olg trifluoride boroethylamine latent curing accelerator, 0.3g carbon black MA-7, 0.5g other additives (including 0.3g dispersant BYK168, O.lg leveling agent BYK 394, O.lg defoamer BYK354); milling with three rollers firstly, then dissolving and dispersing with high-speed stirring; and filtering to obtain the glue solution, and storing it in dark light for later use.

The latent heat curing accelerators and other additives are not listed in Table 1.

**Table 1**

| | | Ex . 1 | Ex .2 | Ex .3 | Ex .4 | Ex .5 | Ex .6 | Ex .7 | Ex .8 | Ex .9 | Ex. 10 | Ex . 11 | Cp. Ex. 1 | Cp. Ex. 2 | Cp. Ex. 3 |
|---|---|---|---|---|---|---|---|---|---|---|---|---|---|---|---|
| Alkali-sol uble resin | ZAR-103 5^{∗}1 | 15 .0 | 15 .0 | 15 .0 | - | - | 15 .0 | 15 .0 | 15 .0 | 15 .0 | 15. 0 | 15 .0 | 15.0 | 15.0 | 15.0 |
| | acrylic resin^{∗}2 | - | - | - | 15 .0 | - | - | - | - | - | - | - | - | - | - |
| | UXE3000 ^{∗}3 | - | - | - | - | 15 .0 | - | - | - | - | - | - | - | - | - |
| Acrylate monomer | 20EOBP DMA | 1. 5 | 1. 5 | 1. 5 | 1. 5 | 1. 5 | 1. 5 | 1. 5 | 1. 5 | 1. 5 | 0.2 9 | 1. 7 | 1.5 | 1.5 | 1.5 |
| | 10EOTM PTA | 1. 0 | 1. 0 | 1. 0 | 1. 0 | 1. 0 | 1. 0 | 1. 0 | 1. 0 | 1. 0 | 0.1 9 | 1. 1 | 1.0 | 1.0 | 1.0 |
| Photoiniti ator | 184^{∗}6 | 0. 2 | 0. 2 | 0. 2 | 0. 04 | 0. 2 | 0. 2 | 0. 2 | 0. 2 | 0. 2 | 0.0 04 | 0. 38 | 0.2 | 0.2 | 0.2 |
| | 907^{∗}7 | 0. 3 | 0. 3 | 0. 3 | 0. 06 | 0. 3 | 0. 3 | 0. 3 | 0. 3 | 0. 3 | 0.0 06 | 0. 58 | 0.3 | 0.3 | 0.3 |
| | ITX^{∗}8 | 0. 05 | 0. 05 | 0. 05 | 0. 01 | 0. 05 | 0. 05 | 0. 05 | 0. 05 | 0. 05 | 0.0 01 | 0. 01 | 0.05 | 0.05 | 0.05 |
| Low dielectric epoxy resin | ^{∗}9 | 2. 7 | 1. 8 | 0. 96 | 1. 8 | 1. 8 | - | - | - | - | - | - | - | 1.8 | 3.5 |
| | ^{∗}10 | - | - | - | - | - | 1. 8 | 2. 1 | - | - | 1.8 | 1. 8 | - | - | - |
| | ^{∗}11 | - | - | - | - | - | - | - | 1. 8 | - | - | - | | | |
| | ^{∗}12 | - | - | - | - | - | - | - | - | 1. 8 | - | - | | | |
| Epoxy resin | NPES-90 1^{∗}13 | - | 0. 9 | 1. 44 | 0. 9 | 0. 9 | 0. 9 | 1. 4 | 0. 9 | 0. 9 | 0.9 | 0. 9 | 2.7 | 0.9 | - |
| Toughene d epoxy resin | MX154^{∗}1 4 | 0. 8 | 0. 8 | 0. 8 | 0. 8 | 0. 8 | 0. 8 | - | 0. 8 | 0. 8 | 0.8 | 0. 8 | 0.8 | 0.8 | - |
| Pigment | MA-7^{∗}15 | 0. 3 | 0. 3 | 0. 3 | 0. 3 | 0. 3 | 0. 3 | - | 0. 3 | 0. 3 | 0.3 | 0. 3 | 0.3 | 0.3 | 0.3 |

| | | | | | | | | | | | | | | | |
|---|---|---|---|---|---|---|---|---|---|---|---|---|---|---|---|
| ^{∗}1: The bisphenol A type carboxyl group containing epoxy acrylic resin ZAR-1035 (Nippon Kayaku, acid value 100mg KOH/g, solid content 64%) ^{∗}2: The acrylic resin, n-BMA/EA/MMA/MAA/HEMA/STY (self-synthesized, acid value 120mg KOH/g, molecular weight 15w) ^{∗}3: The urethane type acid group containing resin UXE-3000 (Nippon Kayaku, acid value 100mg KOH/g, solid content 64%) ^{∗}4: 20EOBPDMA is 20 ethoxy bisphenol A dimethacrylate (Sartomer Co., Ltd.) ^{∗}5: 10EOTMPTA is 10 ethoxy trimethylolpropane triacrylate (Sartomer Co., Ltd.) ^{∗}6: Surface photoinitiator, 1-hydroxycyclohexyl phenyl ketone (184) ^{∗}7: Deep photoinitiator, 2-methyl-1-(4-methylthiophenyl)-2-morpholine-1-acetone (907) ^{∗}8: Photosensitizer, 2 isopropyl thioxanthone (ITX) ^{∗}9: Naphthalene ring type low dielectric epoxy resin, EBA-65 (Shanghai Huayi Resin) ^{∗}10: Cyclopentadiene type low dielectric epoxy resin, XD-1000 (Nippon Kayaku) ^{∗}11: Biphenyl type low dielectric epoxy resin, NC-3000 (Nippon Kayaku) ^{∗}12: Crystalline fluorene type epoxy resin, CG500 (Osaka Gas Chemical, epoxy equivalent 310g/eq) ^{∗}13: NPES-901 (solid epoxy resin, manufactured in Nanya, epoxy equivalent 450-500g/eq) ^{∗}14: MX-154 (core-shell rubber toughened epoxy resin, Kaneka, epoxy equivalent 301g/eq, polybutadiene rubber) ^{∗}15: Carbon black MA-7 (Mitsubishi Chemical, average particle size 24 nm, pH value 3.0, furnace black) | | | | | | | | | | | | | | | |

The following evaluations were performed on the resin composition cured films of the obtained Examples and Comparative Examples for high-frequency and high-speed printed wiring boards:

### 1. Resolution

Film RP-4: µm, L/S=n/400 may be adopted to evaluate the resolution, and a scanning electron microscope (SEM) may be adopted to observe after development. The minimum line width with good side morphology and complete development is used as the evaluation standard.

### 2. Cured film bending resistance test

The cured films in the examples and comparative examples were subjected to an angle of 180° fold test, and the number of times that cracks started to appear is recorded and evaluated based on the following criteria.
⊚: Fold 6 times, no cracks appear on the cured film;
○: Fold 6 times, slight cracks appear on the cured film;
X: Fold once, the cured film is broken

### 3. Comparison of soldering heat resistance

Referring to IPC-TM650.2.6.8 standard, the cured film is immersed vertically in a tin furnace at a temperature of 300°C and soaked for 10 seconds each time. Observing is performed whether the surface is blistered, discolored, floated, peeled, etc., and the appearance change is evaluated based on the following criteria.
⊚ : No change presents in the appearance of the cured film;
○: Discoloration presents on the surface of the cured film;
X: The cured film has floating, thin separation and deep soldering.

### 4. Measurement of dielectric constant (Dk) and dielectric loss (Df)

The cured films obtained in the Examples and Comparative Examples are dried at 150°C for 30 minutes. Dielectric constant and dielectric loss are measured at a frequency of 10GHz for each resin composition using a resonator (Agilent E5071BENA) under the conditions of 25°C and 50% RH by the separation dielectric resonator (SPDR) method.

### 5. Electrical insulation test

The cured films are placed in a constant temperature of 85°C and humidity box of 85% RH for 24 hours, and then the surface resistances and volume resistances are tested. The test conditions is at 50V for 1 min.
⊚ : The insulation resistance after humidification is above 10⁹ without copper migration;
○: The insulation resistance after humidification is above 10⁹ with copper migration;
X: The insulation resistance after humidification is below 10⁹ with copper migration.

### 6. Resilience test

Referring to the ring stiffness measurement method, the cured films are made into a test ring with a width of 10mm and a circumference of 60mm. The force required to compress the ring by 10mm is recorded in the radial direction. Then the external force is quickly removed and the radial heights that the ring can recover are recorded. The smaller the resilience, the better.
⊚ : Resilience <40mN/mm
○: 40 ≤ Resilience < 50mN/mm
X: Resilience ≥50mN/mm

**Table 2: Comparison of cured film performance test**

| | Resolution (µ m) | Bending | Soldering heat resistance | Dk | Df | Electrical insulation | Resilience |
|---|---|---|---|---|---|---|---|
| Ex. 1 | 60 | ⊚ | ⊚ | 2.4 | 0.003 | ⊚ | ⊚ |
| Ex. 2 | 55 | ⊚ | ⊚ | 2.7 | 0.005 | ⊚ | ⊚ |
| Ex. 3 | 50 | ⊚ | ⊚ | 2.9 | 0.007 | ⊚ | ⊚ |
| Ex. 4 | 55 | ⊚ | ⊚ | 2.7 | 0.006 | ⊚ | ⊚ |
| Ex. 5 | 55 | ⊚ | ⊚ | 2.8 | 0.008 | ⊚ | ⊚ |
| Ex. 6 | 55 | ⊚ | ⊚ | 2.7 | 0.006 | ⊚ | ⊚ |
| Ex. 7 | 60 | ○ | ⊚ | 2.8 | 0.007 | ⊚ | ○ |
| Ex. 8 | 55 | ⊚ | ⊚ | 2.8 | 0.006 | ⊚ | ⊚ |
| Ex. 9 | 57 | ⊚ | ⊚ | 2.7 | 0.006 | ⊚ | ⊚ |
| Ex. 10 | 62 | ⊚ | ⊚ | 2.8 | 0.007 | ⊚ | ○ |
| Ex. 11 | 58 | ○ | ⊚ | 2.8 | 0.007 | ⊚ | ⊚ |
| Cp. Ex. 1 | 80 | ⊚ | ○ | 3.5 | 0.012 | ⊚ | X |
| Cp. Ex. 2 | 55 | ⊚ | ⊚ | 3.0 | 0.010 | ⊚ | ○ |
| Cp. Ex. 3 | 60 | X | ⊚ | 2.4 | 0.003 | ⊚ | X |

It can be seen from Table 2 that adding a low-dielectric epoxy resin to the photosensitive resin composition can improve the dielectric properties of the cured film, and significantly reduce the dielectric constant and dielectric loss factor. The dielectric constant is reduced from 3.5 to below 3.0. The electrical loss factor is reduced from 0.012 to less than 0.008, such that the requirements of high-frequency and high-speed PCBs and FPCBs can be met, thereby obtaining a photosensitive solder resist protective layer with both high resolution and excellent dielectric properties. At the same time, the special molecular structure of the low-dielectric epoxy resin can further improve the heat resistance of the cured film and has little effect on its resilience, so that the flexibility and bending resistance of the solder mask will not be reduced.

The illustrated above are only the preferred embodiments for the present disclosure, and are not used to limit the present disclosure. For those skilled in the art, the present disclosure can have various modifications and changes. Any modification, equivalent replacement, improvement, etc. made within the spirit and principle of the present disclosure should be included in the protection scope of the present disclosure.

## Claims

1. A resin composition, **characterized in that**, in parts by weight, the resin composition comprises 100 parts of alkali-soluble resin, 5-30 parts of acrylate monomers, 0.1-10 parts of photoinitiator, 10-30 parts of a first epoxy resin and 0-15 parts of a second epoxy resin; among them, the first epoxy resin is a low-dielectric epoxy resin with a dielectric constant of <3.5, and the second epoxy resin is different from the first epoxy resin.

2. The resin composition according to claim 1, **characterized in that** the low dielectric epoxy resin is an epoxy resin containing at least two epoxy groups and an epoxy equivalent of 160-2000 g/eq;
the low dielectric epoxy resin is preferably selected one or more from a group consisting of biphenyl type epoxy resin, naphthalene ring type epoxy resin, naphthol type epoxy resin, naphthylene ether type epoxy resin, polyphenylene ether type epoxy resin, dicyclopentadiene phenolic type epoxy resin and crystalline fluorene type epoxy resin, and more preferably the naphthalene ring type epoxy resin.

3. The resin composition according to claim 2, **characterized in that** the biphenyl type epoxy resin has a structure shown in formula I: 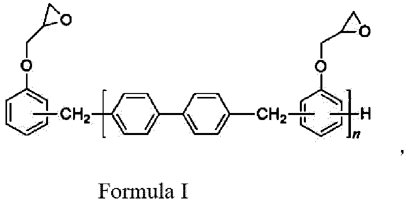 n is a natural number of 1 to 10;
the naphthalene type epoxy resin has a structure shown in formula II: 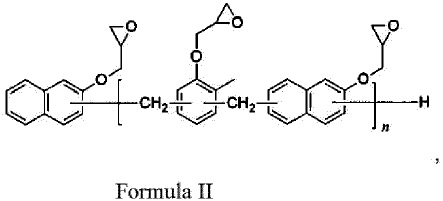 n is a natural number of 1 to 10;
the naphthol type epoxy resin has a structure shown in formula III: 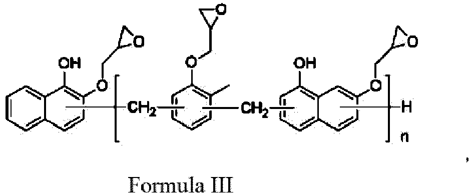 n is a natural number of 1 to 10;
the naphthyl ether type epoxy resin has a structure shown in formula IV: 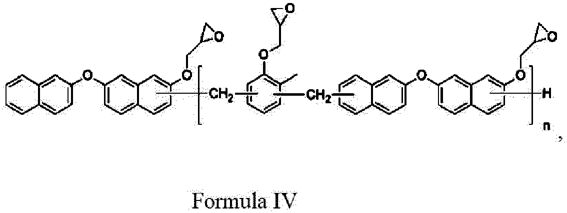 n is a natural number of 1 to 10;
the polyphenylene ether type epoxy resin has a structure shown in formula V: 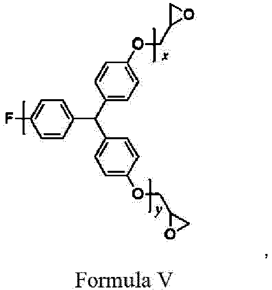 x and y are natural numbers of 1 to 10, respectively;
the bicyclopentadiene phenolic type epoxy resin has a structure shown in formula VI: 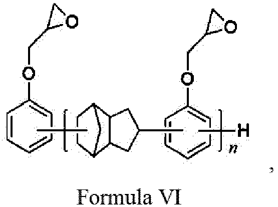 n is a natural number of 1 to 10;
the crystalline anthracene type epoxy resin has a structure shown in formula VII:

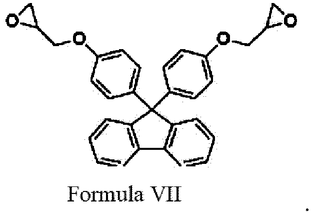

4. The resin composition according to any one of claims 1 to 3, **characterized in that** an acid value of the alkali-soluble resin is 60 to 150 mg KOH/g;
preferably, the alkaline soluble resin is selected one or more from a group consisting of photosensitive epoxy acrylic resin, Phenylacrylic resin, photosensitive polyurethane acrylic acid resin;
preferably, the photosensitive epoxy acrylic resin is selected one or more from a group consisting of carboxylic acid-modified bisphenol A epoxy resin, carboxylic acid modified bisphenol F epoxy resin, carboxylic acid modified phenolic epoxy resin, carboxylic acid modified o-cresol epoxy resin;
preferably, the Phenylacrylic resin is selected from carboxylic acid-modified Phenylacrylic resins with a weight average molecular weight of 3-20w and a glass transition temperature of 90-150°C;
preferably, the photosensitive polyurethane acrylic acid resin is selected from one or more of an aliphatic polyurethane acrylic resin, an alicyclic urethane acrylic resin, an aromatic polyurethane acrylic acid resin.

5. The resin composition according to any one of claims 1 to 3, **characterized in that** the weight average molecular weight of the acrylate monomer is 200 to 2000, and the glass transition temperature is -20 to 100°C;
preferably, the acrylate monomer is selected one or more from a group consisting of (ethoxy) phenol (meth)acrylate, stearic acid acrylate, ethoxy (propoxy) nonylphenol (meth)acrylate, ethoxy (propoxy) tetrahydrofurfuryl (meth)acrylate, 1,6-hexanediol diacrylate, PPG (400) diacrylate, tricyclodecane dimethanol diacrylate, dioxane alkyl glycol diacrylate, ethoxylated (propoxylated) bisphenol A di(meth)acrylate, polyethylene glycol (400) diacrylate, polypropylene glycol (600) diacrylate, ethoxylated (propoxylated) bisphenol A di(meth)acrylate, pentaerythritol triacrylate, tris(2-hydroxyethyl) isocyanurate triacrylate, dipentaerythritol hexaacrylate, ethoxylated pentaerythritol tetraacrylate, dipentaerythritol hexaacrylate.

6. The resin composition according to any one of claims 1 to 3, **characterized in that** the photoinitiator comprises a photopolymerization initiator and a photosensitizer, and a weight ratio of the photopolymerization initiator and the photosensitizer is (2-20):1;
preferably, the photopolymerization initiator is selected one or more from a group consisting of 1-hydroxycyclohexyl phenyl ketone, 2-hydroxy-2-methyl-1-phenyl-1-acetone, 1-[4-(2-hydroxy)-phenyl)-3-hydroxy-2-methyl-1-acetone-1-ketone, 2-methyl-1-(4-methylthiophenyl)-2-morpholine-1-acetone, 2-phenylbenzyl-2-dimethylamine-1-(4-morpholinbenzylphenyl) butanone, 2,4,6-trimethylbenzoyl-diphenylphosphorus oxide, bis(2,4,6-trimethylbenzoyl)phenyl phosphine oxide and ethyl 2,4,6-trimethylbenzoylphenylphosphonate;
preferably, the photosensitizer is selected one or more from a group consisting of 2,4-diethyl oxalate, 2-isopropyl thioxanthone, 2,4-diethyl thioxanthone, benzophenone, polybutylene glycol bis(9-oxo-9H-thioxanthoxyacetic acid) ester.

7. The resin composition according to any one of claims 1 to 6, **characterized in that**, in parts by weight, the resin composition further comprises 3-10 parts of a toughening resin;
preferably, the toughening resin is selected one or more from a group consisting of core-shell rubber toughened epoxy resin, thermoplastic elastomer, polyurethane elastomer, liquid rubber, and rubber powder.

8. The resin composition according to claim 7, **characterized in that**, in parts by weight, the resin composition further comprises 0-5 parts of pigment and 0.01-5 parts of additive; the additive is selected one or more from a group consisting of thermal curing accelerator, dispersant, leveling agent, defoaming agent;
preferably, the pigment is selected one or more from a group consisting of benzidine yellow, phthalocyanine green, phthalocyanine blue, carbon black, silicon dioxide, barium sulfate, calcium sulfate, talc powder, hydrotalcite;
preferably, the thermal curing accelerator is a latent thermal curing accelerator, and more preferably the thermal curing accelerator is selected one or more from a group consisting of boron trifluoride ethylamine complex, adipic acid dihydrazide, p-hydroxybenzoic acid hydrazide, isophthalic acid hydrazide, diaminodiphenyl sulfone, dicyandiamide and derivatives thereof.

9. The resin composition according to claim 8, **characterized in that**, in parts by weight, the resin composition comprises 100 parts of the alkali-soluble resin, 5-30 parts of the acrylate monomer, and 0.1-10 parts of the photoinitiator, 10-30 parts of the first epoxy resin, 0-15 parts of the second epoxy resin, 5-7 parts of the toughening resin, 1-5 parts of the pigment, and 1-5 parts of the additive.

10. Use of a resin composition according to any one of claims 1 to 9 in a field of high-frequency and high-speed printed circuit board.

11. A method for preparing a solder resist protective layer for a high-frequency and high-speed printed circuit board, **characterized in that** comprising the following steps:
roll-coating a resin composition according to any one of claims 1 to 9 into a film to form a wet film;
performing hot roll filming, exposing, developing, and thermal curing sequentially after the wet film is pre-dried, so as to obtain the solder resist protective layer.

12. The method according to claim 11, **characterized in that** a thickness of the wet film is 25-50 µm;
preferably, in a pre-drying process, a pre-drying temperature is 80°C-100°C, and a duration is 15-30 min;
preferably, an exposure energy during an exposing process is 100-500mJ cm⁻²; preferably, during a developing process, a developer used is 0.8-1.2wt% Na₂CO₃ solution, and a developing time is 30-60s, a developing temperature is 27-33 °C, and a spray pressure is 0.2-0.4 MPa;
preferably, during a thermal curing process, a thermal curing temperature is 150-200°C, and a thermal curing duration is 1-1.5h.
